# EUROPÄISCHE PATENTSCHRIFT

(11) **EP 0 783 179 B1**
(45) Veröffentlichungstag und Bekanntmachung des Hinweises auf die Patenterteilung: **17.05.2006**
(21) Anmeldenummer: 96119305.9
(22) Anmeldetag: 02.12.1996
(51) Int. Cl.: H01L 21/768, H01L 21/316

(54) **Herstellverfahren für eine Siliziumoxid-Schicht auf einer Topographie**
Manufacturing method of a SiO2 layer on a topography
Méthode de fabrication d'une couche de SiO2 sur une topographie

(30) Priorität: 05.01.1996 DE 19600305
(43) Veröffentlichungstag der Anmeldung: 09.07.1997
(73) Patentinhaber: Infineon Technologies AG, 81669 München (DE)
(72) Erfinder: Többen, Dirk, Dr., 80796 München (DE); Groteloh, Dörthe, 85521 Ottobrunn (DE); Spindler, Michael, Dr., 85591 Vaterstetten (DE); Rogalli, Michael, Dr., 84056 Rottenburg (DE)
(74) Vertreter: Banzer, Hans-Jörg

(56) Entgegenhaltungen:
- EP-A- 0 610 899
- IEEE TRANSACTIONS ON COMPONENTS,HYBRIDS,AND MANUFACTURING TECHNOLOGY, Bd. 16, Nr. 1, 1.Februar 1993, Seiten 46-51, XP000370035 GARROU P E ET AL: "RAPID THERMAL CURING OF BCB DIELECTRIC"

## Beschreibung

Die Erfindung betrifft ein Herstellverfahren für eine als Intermetalldielektrikum fungierende SiO₂-Schicht auf einer Topographie, insbesondere auf einer Al-Topographie.

Für die metallischen Leitbahnen in integrierten Schaltungen wird fast ausschließlich Aluminium verwendet. Wegen des Aluminium-Silizium-Eutektikums bei 570° C sind die Prozeßtemperaturen auf den Bereich unterhalb ca. 500° C beschränkt, sobald Aluminium auf der Siliziumscheibe abgeschieden ist. Als Isolationsschichten zwischen übereinanderliegenden Aluminiumebenen werden SiO₂-Schichten verwendet.

Solche SiO₂-Isolationsschichten werden bisher in der Hauptsache über SiO₂-CVD-Abscheideverfahren erzeugt, von denen im einzelnen nur das sogenannten Silanverfahren, das LTO-Verfahren und das Plasmaoxid-Verfahren in Frage kommen, weil die beiden anderen gängigen Verfahren, das TEOS-Verfahren einerseits und das HTO-Verfahren andererseits, bei Temperaturen weit oberhalb 500° C stattfinden. Der Hauptnachteil dieser gängigen Abscheideverfahren liegt darin, daß die so abgeschiedenen SiO₂-Schichten im günstigsten Fall nur lokal planarisiert sind. Demzufolge müssen diese Schichten mit aufwendigen weiteren Prozeßschritten planarisiert werden z.B. über chemical-mechanical-polishing bzw. über planarizing-resist-etchback. Eine gute Planarisierung ist aber wegen den depth-of-focus-Erfordernissen in den nachfolgenden Strukturierungsschritten dringend erforderlich.

Ein anderer Nachteil liegt bei den so abgeschiedenen SiO₂₋Schichten darin, daß diese in der Regel eine Dielektrizitätskonstante ε ≥ 3,5 aufweisen. Diese relativ hohe Dielektrizitätskonstante führt bei den resultierenden integrierten Schaltungen häufig dazu, daß sogenannte parasitäre Kapazitäten auftreten, die zu einer Erhöhung der Signalübermittlungszeiten führt.

Im Dokument "Rapid Thermal Curing of BCB Dielectric" Garrou *et al, IEEE Transactions on Components, Hybrids and Manufacturing Technology* wird das Polymerisieren eines Organodisiloxans durch Rapid Thermal Curing beschrieben. Dieses Dokument offenbart keinen weiteren Zersetzungsschritt. Die europäische Patentanmeldung EP0610899 offenbart das Herstellen einer SiO₂-Schicht wobei eine Silikonharzschicht kalziniert wird.

Eine weitere Methode zur Erzeugung von SiO₂-Schichten ist das Sputtern. Gesputterte SiO₂-Schichten weisen aber den Nachteil auf, daß die Aufwachsraten (ca. 1 µm pro Stunde) sehr gering sind und auch häufig ein zu starker Partikelbefall auf die Scheiben während der Sputterbeschichtung stattfindet.

Sowohl über CVD-Verfahren abgeschiedene SiO₂-Schichten als auch gesputterte SiO₂-Schichten erzielen auf Topographien in der Regel nur mittelgute Kantenbedeckungen, die problematisch sind, wenn die Flanken der Aluminiumstrukturen sehr steil sind. Ferner sind beide Verfahren apparativ sehr aufwendig.

In jüngerer Zeit wurden Verfahren bekannt, bei denen sogenannte Spin-On-Glasschichten erzeugt werden. Dabei werden entweder Silanole oder Siloxane, die in einem Lösungsmittel gelöst sind, auf die Topographie aufgebracht und dann bei erhöhter Temperatur über eine Polykondensationsreaktion vernetzt. Dadurch wird zwar ein zumeist guter lokaler Planarisierungsgrad erreicht, die maximale Schichtdicke aufgrund von Rißbildungen ist aber auf ca. 1 µm begrenzt und vor allem eine langreichweitige Planarisierung kann nicht erzielt werden.

Aufgabe der vorliegenden Erfindung ist es daher, ein Herstellverfahren für eine als Intermetalldielektrikum fungierende SiO₂-Schicht auf einer Topographie, insbesondere auf einer Al- Topographie, zu entwickeln, welche sowohl kurz- als auch langreichweitige Planarisierungseigenschaften aufweist, eine gegenüber abgeschiedenen SiO₂-Schichten merklich geringere Dielektrizitätskonstante aufweist und apparativ einfach zu erzeugen ist.

Erfindungsgemäß wird die Aufgabe durch ein Herstellverfahren mit folgenden Schritten gelöst:
a) Auf die Topographie wird ein in einem organischen Lösungsmittel gelöstes Organodisiloxan der allgemeinen Formel R₁(R₂)₂Si-O-Si(R₂)₂R₁ aufgebracht, worin R₂ einen Alkylrest oder Wasserstoff und R₁ einen polymerisierbaren organischen Rest bedeutet,
b) das Organodisiloxan wird polymerisiert,
c) das entstandene Polymerisat wird pyrolythisch und/oder photolythisch und/oder durch Elektronenbestrahlung zersetzt, wobei das Polymerisat zu einer stark SiO₂-haltigen Schicht wird.

Die so entstandenen Schichten lassen sich mit geringem apparativem Aufwand erzielen, weisen eine hervorragende kurz- und langreichweitige Planarisierungseigenschaft auf, insbesondere weisen sie eine exzellente Kantenbedeckung auch bei Aluminiumstrukturen mit sehr steilen Flanken auf und besitzen eine Dielektrizitätskonstante ε < 3. Dadurch können parasitäre Kapazitäten in den integrierten Schaltungen und damit schlechte Signalübermittlungszeiten verringert bzw. ausgeschlossen werden.

Vorzugsweise ist der polymerisierbare organische Rest ein Vinylcyclobutabenzol-Rest und die übrigen freien Bindungen der Silizium-Atome werden durch Methylgruppen abgesättigt. Dieses Divinylsiloxan-bis-Benzocyclobuten wird typischerweise in dem organischen Lösungsmittel Mesitylen gelöst. Die Erfahrung hat gezeigt, daß dieses Divinylsiloxan-bis-Benzocyclobuten besonders gut zur Erzeugung von SiO₂-Schichten auf Topographien geeignet ist.

Typischerweise werden die in einem organischen Lösungsmittel gelösten Organodisiloxane mittels einer Schleuderbeschichtung aufgebracht. Die Schleuderbeschichtung ist eine apparativ besonders gut handhabbare und mitunter die billigste Methode der Schichterzeugung in der Siliziumtechnologie. Andere Aufbringungsarten neben dem Aufschleudern wie z. B. Aufrollen bzw. Aufwalzen sind aber ebenfalls denkbar.

Vorzugsweise wird das Divinylsiloxan-bis-Benzocyclobuten bei einer Temperatur von ca. 250° C polymerisiert und das Polymerisat danach in zumindest zwei aufeinanderfolgenden Pyrolysezyklen bei einer Temperatur von ca. 450° C zersetzt. Unter Pyrolysezyklus ist hierbei zu verstehen, daß der Wafer von Raumtemperatur auf 450° C erwärmt wird und danach wieder auf Raumtemperatur rückgekühlt wird.

Die Erfindung ist in der Zeichnung beispielsweise veranschaulicht und im nachstehenden im einzelnen anhand der Zeichnung beschrieben. Es zeigen:
- FIG 1: eine Strukturformel des Divinylsiloxan-bis-Benzocyclobuten (DVS-BCB),
- FIG 2: eine schematische Darstellung der Schleuderbeschichtung,
- FIG 3: die Struktur von vernetztem DVS-BCB und
- FIG 4: Infrarot-Spektren von einem DVS-BCB-Polymerisat vor und nach zweimaliger thermischer Belastung bis 450° C.

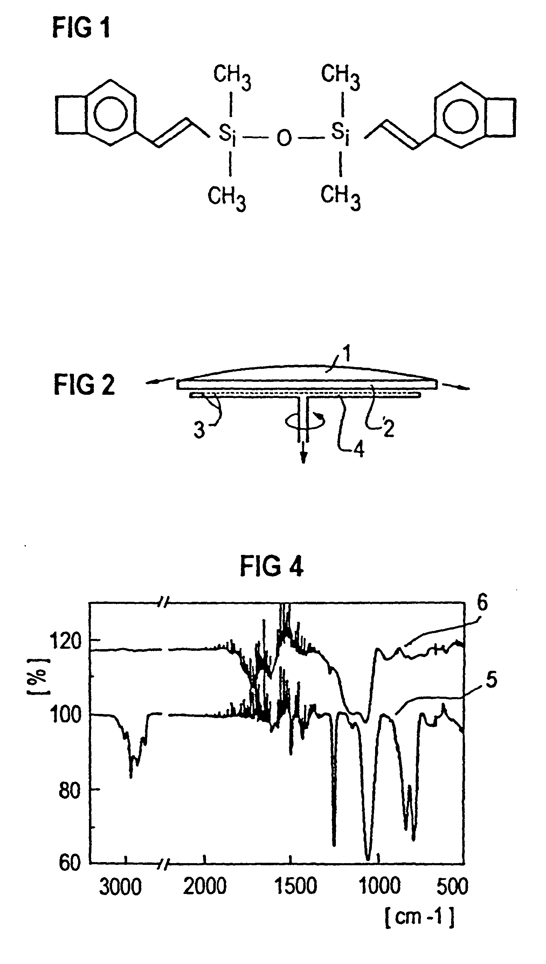

FIG 1 zeigt das bevorzugte Monomer aus der Substanzklasse der Organodisiloxane nach der Erfindung. Dieses Divinylsiloxan-bis-Benzocyclobuten (DVS-BCB) wird über Schleuderbeschichtung auf die Wafertopographie aufgebracht. Das Prinzip der Schleuderbeschichtung ist aus FIG 2 zu sehen. Das in dem organischen Lösungsmittel Mesitylen gelöste DVS-BCB 1 wird auf die Wafertopographie 2 aufgetropft, die mittels Vakuumansaugung 3 zentrisch auf einem Schleuderteller 4 festgehalten wird. Bei typischerweise 3000 min⁻¹ wird die Beschichtung, die vorzugsweise 38 % DVS-BCB enthält, durch die Zentrifugalkraft bis auf eine dünne verbleibende Schicht radial nach außen geschleudert. Danach schließt sich ein Trocknungsschritt bei ca. 250° C auf einer Heizplatte (hot plate) (nicht gezeigt) oder in einem Konfektionsofen an. Der dabei entstehende Film weist ungefähr eine Dicke von 1,6 µm auf.

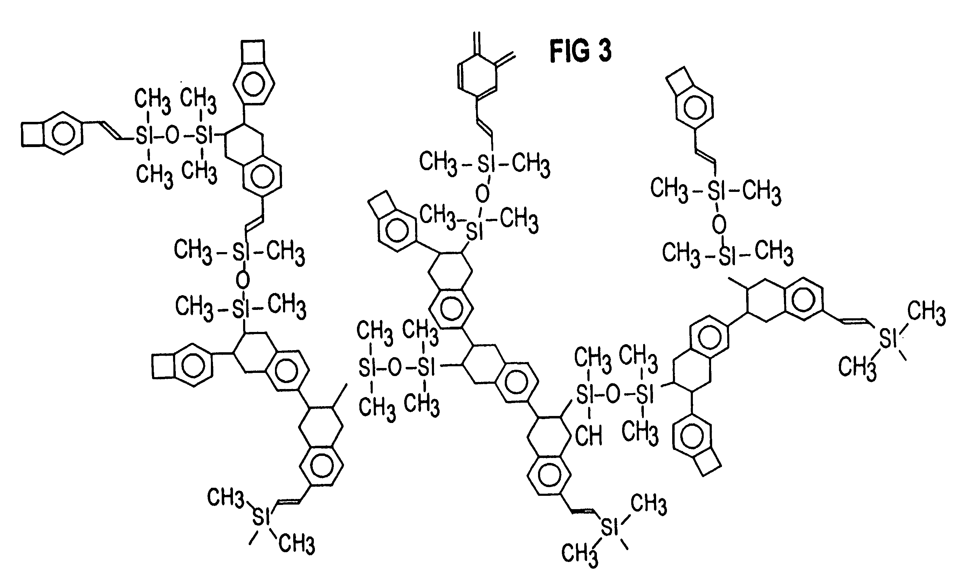

Aus der FIG 3 ist zu ersehen, daß die in FIG 1 gezeigten Monomere über eine Polyadditionsreaktion zwischen Vinyl-Gruppen und den Cyklobuten-Gruppen zu einem Polymer vernetzen. Dieses Polymer wird dann in einer thermischen Behandlung bei ca. 450° C zersetzt, so daß nur noch ein SiO₂-Gerüst mit wenigen organischen Rückständen bestehen bleibt. Damit geht eine sehr starke Filmdickenreduzierung einher. Der ursprünglich 1,6 µm dicke Film schrumpft dabei um ca. 60 %. Die hervorragenden kurz- und langreichweitigen Planarisierungseigenschaften bleiben jedoch erhalten. Auch wird damit ein Planarisierungsgrad von nahezu 90 % erzielt.

Die in FIG 4 gezeigten Infrarotspektren des vernetzten DVS-BCB 5 und des DVS-BCB-Films 6 nach zwei thermischen Zyklen zwischen Raumtemperatur und 450° C lassen erkennen, daß die mit Schwingungen in den aromatischen Ringen verbundenen Peaks bei ca. 2900 cm⁻¹ und ca. 800 cm⁻¹ vollständig verschwunden sind. Gleiches gilt für die Si-CH₃-Schwingungen bei ca. 1250 cm⁻¹ und ca. 850 cm⁻¹. Ferner bleiben aber die Si-O-Si-Biegeschwingungen bei ca. 1050 cm⁻¹ erhalten, so daß davon ausgegangen werden kann, daß sich eine SiO₂-Struktur ausgebildet hat. Dies wird noch dadurch unterstützt, daß der anfangs relativ kleine Peak bei ca. 1150 cm⁻¹ an Intensität sehr stark zugenommen hat. Dieser Peak kann als Si-O-Streckschwingung wieder identifiziert werden. Ferner bildet sich eine kleine Schulter bei ca. 1150 cm⁻¹ aus, was von neu entstandenen - C=C-Bindungen herrühren kann. Das IR-Spektrum nach der thermischen Belastung des DVS-BCB-Films ist ingesamt auffallend ähnlich zu den IR-Spektren von CVD-SiO₂ bzw. von Spin-on-Gläsern.

Die organischen Rückstände und die relativ lose Dichte des thermisch behandelten DVS-BCB-Films führen zu einer merklichen Reduzierung der Dielektrizitätskonstante gegenüber CVD-SiO₂. Dies wiederum führt merklich zu einer Reduzierung parasitärer Kapazitäten in den damit hergestellten integrierten Schaltungen.

## Patentansprüche

1. Herstellverfahren für eine als Intermetalldielektrikum (IMD) fungierende SiO₂-Schicht auf einer Topographie, insbesondere auf einer Al- Topographie, mit folgenden Schritten:
a) Auf die Topographie wird ein in einem organischen Lösungsmittel gelöstes Organodisiloxan der allgemeinen Formel R₁(R₂)₂Si-O-Si(R₂)₂R₁ aufgebracht, worin R₂ einen Alkylrest oder Wasserstoff und R₁ einen polymerisierbaren organischen Rest bedeutet,
b) das Organodisiloxan wird polymerisiert, und
c) das entstandene Polymerisat wird pyrolythisch und/oder photolythisch und/oder durch Elektronenbestrahlung zersetzt, wobei das Polymerisat zu einer SiO₂ Schicht wird.

2. Herstellverfahren nach Anspruch 1,
**dadurch gekennzeichnet, daß**
R₁ ein Vinylcyclobutabenzol-Rest und R₂ ein Methylrest ist.

3. Herstellverfahren nach Anspruch 1 oder 2,
**dadurch gekennzeichnet, daß**
als organisches Lösungsmittel Mesitylen verwendet wird.

4. Herstellverfahren nach einem der Ansprüche 1 bis 3,
**dadurch gekennzeichnet, daß**
das in einem organischen Lösungsmittel gelöste Organodisiloxan mittels einer Schleuderbeschichtung aufgebracht wird.

5. Herstellverfahren nach einem der Ansprüche 2 bis 4,
**dadurch gekennzeichnet, daß**
Divinylsiloxan-bis-Benzocyclobuten bei einer Temperatur von 250° C polymerisiert wird.

6. Herstellverfahren nach einem der Ansprüche 2 bis 5,
**dadurch gekennzeichnet, daß**
daß das Polymerisat in zumindest zwei aufeinanderfolgenden Pyrolysezyklen bei einer Temperatur von 450° C zersetzt wird.

## Claims

1. Preparation method for an SiO₂ layer, which acts as an inter-metal dielectric (IMD), on a topography, in particular on an A1 topography, comprising the following steps:
a) there is applied to the topography an organodisiloxane which is dissolved in an organic solvent and has the general formula R₁(R₂)₂Si-O-Si(R₂)₂R₁, in which R₂ represents an alkyl radical or hydrogen and R₁ represents a polymerizable organic radical,
b) the organodisiloxane is polymerized, and
c) the polymer formed is decomposed pyrolytically and/or photolytically and/or by electron irradiation, the polymer changing in the process to become an SiO₂ layer.

2. Preparation method according to Claim 1, **characterized in that** R₁ is a vinylcyclobutabenzene radical and R₂ is a methyl radical.

3. Preparation method according to Claim 1 or 2, **characterized in that** the organic solvent used is mesitylene.

4. Preparation method according to any one of Claims 1 to 3, **characterized in that** the organodisiloxane dissolved in an organic solvent is applied by means of spin-coating.

5. Preparation method according to any one of Claims 2 to 4, **characterized in that** divinylsiloxane-bis-benzocyclobutene is polymerized at a temperature of 250°C.

6. Preparation method according to any one of Claims 2 to 5, **characterized in that** the polymer is decomposed in at least two successive pyrolysis cycles at a temperature of 450°C.

## Revendications

1. Procédé de fabrication d'une couche de SiO₂ servant de diélectrique intermétallique (IMD) sur une topographie, en particulier sur une topographie en Al, comprenant les étapes suivantes :
a) sur la topographie, on dépose, dissous dans un solvant organique, un organodisiloxane, de formule générale R₁(R₂)₂Si-O-Si(R₂)₂R₁, dans laquelle R₂ représente un radical alkyle ou un hydrogène et R₁ représente un radical organique polymérisable,
b) l'organodisiloxane est polymérisé, et
c) le polymère obtenu est décomposé par pyrolyse et/ou par photolyse et/ou par irradiation d'électrons, moyennant quoi le polymère devient une couche de SiO₂.

2. Procédé de fabrication selon la revendication 1, **caractérisé en ce que** R₁ est un radical vinylcyclobutabenzène et R₂ est un radical méthyle.

3. Procédé de fabrication selon la revendication 1 ou 2, **caractérisé en ce que** l'on utilise du mésitylène comme solvant organique.

4. Procédé de fabrication selon l'une des revendications 1 à 3, **caractérisé en ce que** l'organodisiloxane dissous dans un solvant organique est déposé au moyen d'une enduction par projection.

5. Procédé de fabrication selon l'une des revendications 2 à 4, **caractérisé en ce que** le divinylsiloxane bis-benzocyclobutène est polymérisé à une température de 250°C.

6. Procédé de fabrication selon l'une des revendications 2 à 5, **caractérisé en ce que** le polymère est décomposé à une température de 450°C en au moins deux cycles de pyrolyse consécutifs.
